# EUROPEAN PATENT APPLICATION

(11) **EP 2 770 543 A2**
(43) Date of publication of application: **27.08.2014**
(21) Application number: 14153546.8
(22) Date of filing: 31.01.2014
(51) Int. Cl.: H01L 31/048

(54) **Photoelectric device and photoelectric system including the same**

(30) Priority: 31.01.2013 KR 20130011487
(71) Applicant: Samsung SDI Co., Ltd., Yongin-si, Gyeonggi-do (KR)
(72) Inventor: Lee, Seung-Hee, Gyeonggi-do (KR); Jung, Chan-Yoon, Gyeonggi-do (KR); Moon, Jun-Ho, Gyeonggi-do (KR); Lee, Dong-Jun, Gyeonggi-do (KR); Kim, Myung-Hwan, Gyeonggi-do (KR); Jeon, Hoon-Ha, Gyeonggi-do (KR); Kim, Bum-Rae, Gyeonggi-do (KR); Chong, Joong-Gun, Gyeonggi-do (KR)
(74) Representative: Mounteney, Simon James

(57) **Abstract**

A photoelectric device and a photoelectric system including the same are provided. The photoelectric device includes a photoelectric module configured to perform photoelectric conversion and a cover glass facing the photoelectric module and having a receiving space that receives the photoelectric module. The cover glass includes a plate-shaped base part formed to face a main surface of the photoelectric module and a sidewall protruding from an edge of the base part to face a side section of the photoelectric module.

## Description

### BACKGROUND

### 1. Field

The present invention relates to a photoelectric device and a photoelectric system including the same.

### 2. Description of the Related Art

Recently, due to energy resource depletion problems and global environmental problems, the development of clean energy has been accelerated. One potential source of clean energy is a photovoltaic device that uses solar cells to directly convert solar light into electricity.

### SUMMARY

According to one or more embodiments of the present invention, a photoelectric device may include a photoelectric module performing photoelectric conversion; and a cover glass disposed to face the photoelectric module and having a receiving space that receives the photoelectric module, wherein the cover glass includes a plate-shaped base part formed to face a main surface of the photoelectric module and a sidewall protruding from an edge of the base part to face a side section of the photoelectric module.

The side section of the photoelectric module and the sidewall of the cover glass may support each other.

The sidewall of the cover glass may be formed to overlap at least one side section of the photoelectric module.

The sidewall of the cover glass may be formed to overlap all four side sections of the photoelectric module.

The photoelectric module may be coupled to the cover glass by being received in the receiving space of the cover glass.

A sealing material may be disposed between the photoelectric module and the cover glass.

The photoelectric module and the cover glass may be coupled to face each other; and each of the photoelectric module and the cover glass may have a sidewall formed to face a side section of the cover glass or the photoelectric module, each being an opponent of mutual coupling.

The sidewalls of the photoelectric module and the cover glass may be formed at respectively opposite sides.

The photoelectric device may further include a lead wire extending to the outside through a gap between the side section of the photoelectric module and the sidewall of the cover glass.

The lead wire may include: a main body extending along one direction in the photoelectric module; and a connection end extending from the main body to be withdrawn to the outside of the photoelectric module.

The connection end may extend outside in an extension direction of the main body.

The connection end may bend twice from the main body to extend laterally at an offset position from the main body and may extend to the outside.

The connection end may bend once from the main body to extend to the outside along a direction in which the connection end diverges from the main body.

According to one or more embodiments of the present invention, a photoelectric system may include a photoelectric device; and a mounting frame supporting the photoelectric device obliquely at an upper position from the ground, wherein the photoelectric device includes: a photoelectric module performing photoelectric conversion; and a cover glass disposed to face the photoelectric module, wherein the cover glass includes a base part formed to face a main surface of the photoelectric module and a sidewall protruding from an edge of the base part to face a side section of the photoelectric module, and the mounting frame is mounted on one that is placed at a lower side among the photoelectric module and the cover glass.

The sidewall may be formed to overlap at least one side section of the photoelectric module.

The sidewall may be formed to overlap a side section disposed uppermost or lowermost in the photoelectric module.

The cover glass may be supported at an upper part of the photoelectric module; and the sidewall of the cover glass is supported by being caught by a side end of the photoelectric module.

The photoelectric module may be supported at an upper part of the cover glass; and a side end of the photoelectric module may be supported by being caught by the sidewall of the cover glass.

At least some of the above and other features of the invention are set out in the claims.

### BRIEF DESCRIPTION OF THE DRAWINGS

Features of the invention will be made more apparent to those of skill in the art by describing in detail exemplary embodiments with reference to the attached drawings in which:
FIG. 1 illustrates an exploded perspective view of a photoelectric device according to an embodiment of the invention;
FIG. 2 illustrates a cross-sectional view taken along line II-II of FIG. 1;
FIG. 3 illustrates a cross-sectional view of an enlarged portion of FIG. 2;
FIGS. 4a and 4b illustrate views of an extraction structure of a lead wire according to an embodiment of the invention;
FIGS. 5a and 5b illustrate views of an extraction structure of a lead wire according to another embodiment of the invention;
FIGS. 6a and 6b illustrate views of an extraction structure of a lead wire according to another embodiment of the invention;
FIG. 7 illustrates an exploded perspective view of a photoelectric device according to a comparative example;
FIGS. 8a and 8b illustrate views of a penetration path of a foreign material penetrating into a photoelectric device according to an embodiment of the invention and the comparative example, respectively;
FIGS. 9 and 10 illustrate exploded perspective views of photoelectric devices according to different embodiments of the invention;
FIG. 11 illustrates a view of a photoelectric system according to an embodiment of the invention;
FIG. 12 illustrates a view a mounting structure of a photoelectric device according to the comparative example of FIG. 7;
FIGS. 13 to 16 illustrate views of photoelectric systems according to different embodiments of the invention; and
FIG. 17 illustrates a view of a mounting structure of a photoelectric device according to another embodiment of the invention.

### DETAILED DESCRIPTION

Example embodiments of the invention will now be described more fully hereinafter with reference to the accompanying drawings; however, the invention may be embodied in different forms and should not be construed as limited to the embodiments set forth herein. Rather, these embodiments are provided so that this disclosure will be thorough and complete, and will fully convey exemplary implementations to those skilled in the art.

Referring to drawings, the photoelectric device includes a photoelectric module 150 performing photoelectric conversion and a cover glass 110 facing the photoelectric module 150 and having a receiving space G receiving the photoelectric module 150. Although not shown in the drawings, the photoelectric module 150 may include a light absorption layer receiving incident light to generate photogenerated carriers, and a laminate including layers having respectively opposite polarities to withdraw the photogenerated carriers generated from the light absorption layer to the outside.

In more detail, the photoelectric module 150 may include at least one photoelectric cell (not shown). Here, in a broad sense, the photoelectric cell may have various structures, e.g., a silicon-based system (including monocrystalline, polycrystalline, amorphous, or microcrystalline silicon), a compound system (including a group III-V compound semiconductor or a group II-VI compound semiconductor), a crystalline system (including monocrystalline or polycrystalline silicon), an amorphous silicon or CIS system, and a thin film system including a CIGS system. That is, known cells having any one of the mechanisms for performing photoelectric conversion may be used as the photoelectric cell.

Additionally, throughout this specification, the photoelectric module 150 coupled to the cover class 110 may be illustrated as having a single photoelectric cell but this is merely for ease of explanation and embodiments are not limited one photoelectric cell, but may include a plurality of photoelectric cells (not shown) that are electrically coupled to each other in order to obtain a required output performance. For example, the photoelectric module 150 may include a plurality of coupled photoelectric cells that are electrically connected to each other, and a plurality of photoelectric cells may be covered by a single cover glass 110 to form a photoelectric device. When a plurality of photoelectric cells (not shown) are electrically coupled to each other, electrodes of adjacent photoelectric cells (not shown) may be electrically connected to each other through a conductive pattern (not shown).

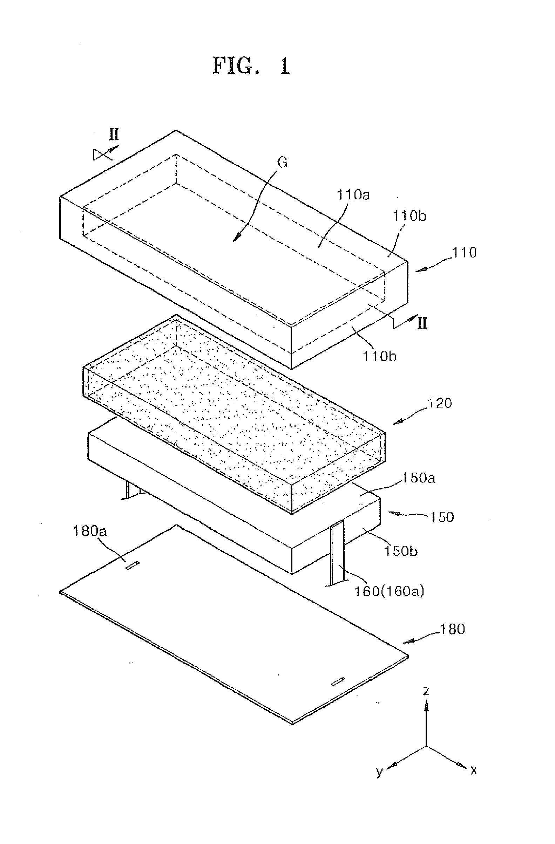

The cover glass 110 includes a base part 110a having a plate shape overall and a sidewall 110b protruding from at least one edge of the base part 110a. The sidewall 110b forms the receiving space G that receives the photoelectric module 150. Here, the receiving space G may be defined by the base part 110a and the sidewall 110b. Although all four edges of the base part 110a are illustrated in FIG. 1 as having sidewalls 110b protruding therefrom, the receiving space G may have at least one side opened, e.g., having no sidewall 110b, and may receive the photoelectric module 150 through the one opened side. The base part 110a faces a main surface 150a of the photoelectric module 150, and the sidewall 110b is disposed to face a side section 150b of the photoelectric module 150.

When the cover glass 110 and the photoelectric module 150 are assembled, the base part 110a is to face the main surface 150a of the photoelectric module 150 and the sidewall 110b is disposed to face the side section 150b of the photoelectric module 150. The sidewall 110b seals the side section 150b of the photoelectric module 150 and serves as a stopping part that prevents the cover glass 110 and the photoelectric module 150 from separating from each other. As described in detail later, the photoelectric device may be obliquely mounted with respect to the ground through a mounting frame (not shown in FIG. 1). In such a configuration, since the sidewall 110b of the cover glass 110 contacts the side section 150b of the photoelectric module 150, this prevents the cover glass 110 and the photoelectric module 150 from sliding relatively in the direction of gravity and being separated from each other.

A sealing material 120 is interposed between the cover glass 110 and the photoelectric module 150. For example, the sealing material 120 may be interposed between the cover glass 110 and the main surface 150a of the photoelectric module 150 and/or may be interposed between the sidewall 110b of the cover glass 110 and the side section 150b of the photoelectric module 150. The sealing material 120 serves to fill the gap between the cover glass 110 and the photoelectric module 150 so as to prevent contaminants, e.g., moisture, from penetrating through the gap.

A lead wire 160 extends to the outside through the gap between the cover glass 110 and the photoelectric module 150. The lead wire 160 is electrically connected to the photoelectric module 150 so as to transmit an electrical output of the photoelectric module 150 to the outside, and may form an electrical path extending to the outside. For example, the lead wire 160 may form an electrical path that transmits the photogenerated carriers resulting from photoelectric conversion using incident light as input to the outside. For example, in the photoelectric module 150 having a plurality of coupled photoelectric cells (not shown), the lead wire 160 is connected to electrodes of photoelectric cells forming both ends in the arrangement of photoelectric cells (not shown), so that an electrical output from the arrangement of photoelectric cells may be transmitted to the outside. Additionally, the lead wire 160 may extend across the photoelectric cells (not shown) in one column, and performs a bus function for electrically coupling adjacent photoelectric cells. The end part of the lead wire 160 extends to the outside so that an electrical output of photoelectric cells (not shown) may be transmitted to the outside. In another embodiment, the lead wire 160 may be connected to a conductive pattern (not shown) that electrically connects each photoelectric cell (not shown) to each other.

Referring to the drawings, a portion of the lead wire 160 that extends outside may form a connection end 160a to connect to an external circuit (not shown) or an external load (not shown). For example, the connection end 160a may contact a circuit substrate (not shown) and may be connected to an external load (not shown) through the circuit substrate. Moreover, a main body unit (not shown) of the lead wire 160 may extend in one direction in the photoelectric module 150.

A base plate 180 for further protecting the photoelectric module 150 is also provided. The base plate 180 includes an opening 180a through which the connection ends 160a of the lead wire 160 extends.

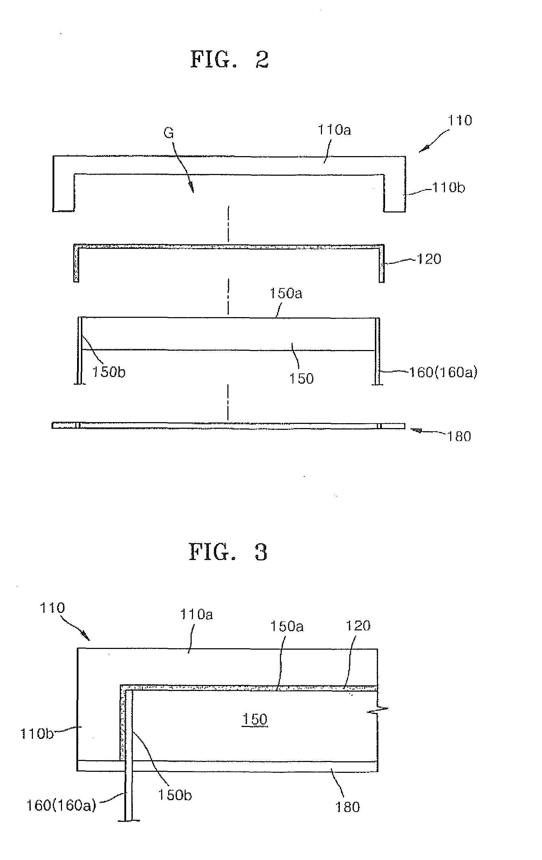

As shown in FIG. 3, the lead wire 160 may extend to the outside through the gap between the cover glass 110 and the photoelectric module 150, or the gap between the sidewall 110b of the cover glass 110 and the side section 150b of the photoelectric module 150. The gap through which the lead wire 160 passes may be sealed with the sealing material 120.

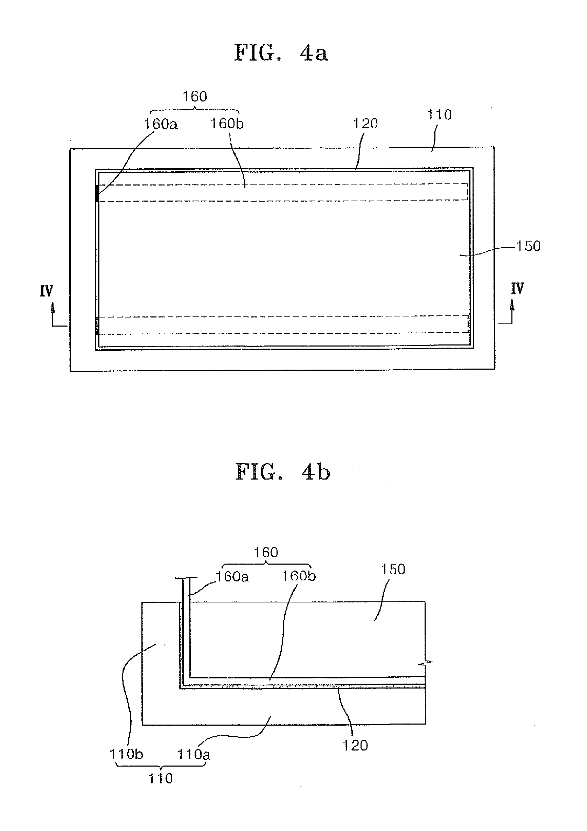

FIG. 4a illustrates a view of the backside of the photoelectric device and FIG. 4b illustrates a cross-sectional view taken along line IV-IV of FIG. 4a. Referring to the drawings, the lead wire 160 extends across the photoelectric module 150, and its end part extends to the outside through the gap between the cover glass 110 and the photoelectric module 150. For example, the photoelectric module 150 may have a configuration in which a plurality of photoelectric cells (not shown) are electrically coupled to each other. In such a configuration, the lead wire 160 may extend across the arrangement of photoelectric cells (not shown) to electrically connect electrodes (not shown) of adjacent photoelectric cells and may extend to the outside through the gap between the cover glass 110 and the photoelectric module 150, so that an electrical output of the photoelectric module 150 may be transmitted to the outside.

The lead wire 160 has the connection end 160a extending outside in order to be connected to an external circuit (not shown) or an external load (not shown). According to the embodiment of FIG. 4a, a main body unit 160b of the lead wire 160 extends in the extension direction of the photoelectric module 150, thereby extending outside. For example, the main body unit 160b of the lead wire 160 extends along the long edge part direction, e.g., along the x-axis direction, of the photoelectric device and the connection end 160a of the lead wire 160 extends to the outside through the short edge part, e.g., along the z-axis direction or stacking direction, of the photoelectric device.

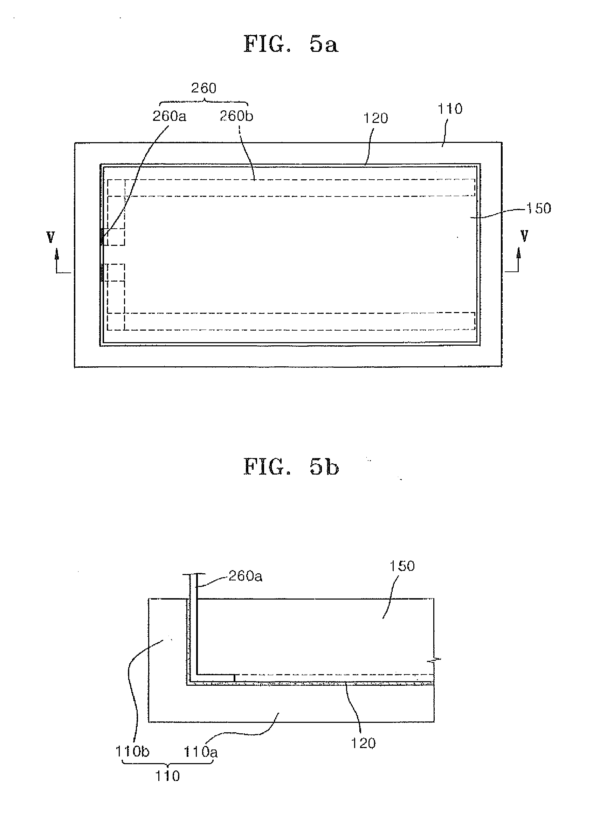

FIG. 5a illustrates an extraction structure of a lead wire 260 according to another embodiment of the invention. FIG. 5b illustrates a cross-sectional view taken along line V-V of FIG. 5a. Referring to the drawings, a connection end 260a of the lead wire 260 has a form bending from a main body unit 260b. For example, the connection end 260a of the lead wire 260 extends parallel to the main body unit 260b at an offset position and may bend twice, so as to extend to the outside. For example, the connection end 260a of the lead wire 260 may be extracted at the center position that is spaced from the main body unit 260b of the lead wire 260 in the short edge part direction. For example, when the extraction position of the lead wire 260 is freely set, the connection end 260a of the lead wire 260 may be easily connected to a circuit substrate (not shown). That is, the degree of freedom on the displacement position of the circuit substrate (not shown) may be increased, and the connection length with the circuit substrate (not shown) may be decreased. In other words, as would be apparent to one of ordinary skill in the art from the foregoing description and FIGS. 5a and 5b, the connection end 260a may extend from an end of the main body unit 260b along the y-axis direction towards a center of the photoelectric device and then extend away from the cover plate 110 along the z-axis direction to extend to the outside.

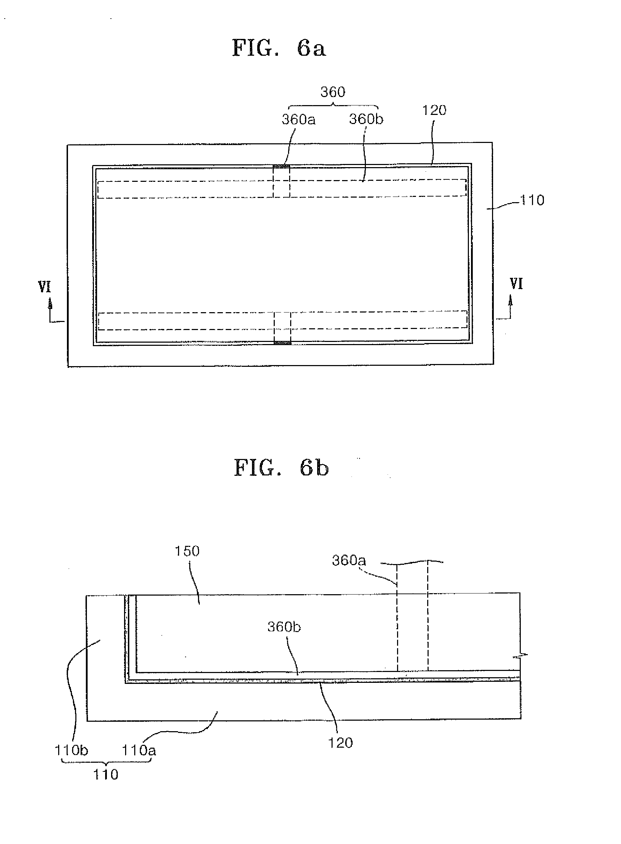

FIG. 6a illustrates a view of an extraction structure of a lead wire 360 according to another embodiment of the invention. FIG. 6b illustrates a cross-sectional view taken along line VI-VI of FIG. 6A. Referring to the drawings, a connection end 360a of the lead wire 360 extends to the outside through the long edge part, e.g., along the x-axis direction, of the photoelectric device. In this regard, a main body unit 360b of the lead wire 360 extends along the long edge part direction of the photoelectric device. Here, the connection end 360a of the lead wire 360 extends in a direction in which it bends from the main body unit 360b and diverges, and extends to the outside at the center position along the long edge part direction. When the extraction position of the lead wire 360 is freely set, the connection end 360a of the lead wire 360 may be easily connected to a circuit substrate (not shown). In other words, as would be apparent to one of ordinary skill in the art from the foregoing description and FIGS. 6a and 6b, the connection end 360a may extend from a central portion of the main body unit 360b away from the cover plate 110 along the z-axis direction to extend to the outside.

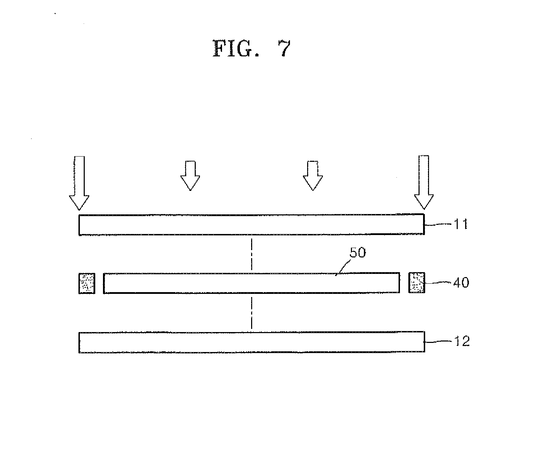

FIG. 7 is a view of a photoelectric device according to a comparative example. Referring to the drawings, the photoelectric device includes upper and lower glass substrates 11 and 12 coupled to each other with a photoelectric module 50 therebetween. A sealing material 40 is interposed along the edges of the upper and lower glass substrates 11 and 12 so as to seal the photoelectric module 50. For example, the sealing material 40 is interposed between the upper and lower glass substrates 11 and 12, and then is pressed by applying pressure in the facing direction of the upper and lower glass substrates 11 and 12, so that the photoelectric device may be formed. At this point, the distribution of the pressure applied to the upper and lower glass substrates 11 and 12 tends to concentrate at the edge portion relatively, as shown in FIG. 7. In this case, the risk of damage on the relatively weak edge portions of the upper and lower glass substrates 11 and 12 may be large. For example, the edge portion of the upper glass substrate 11, to which a predetermined pressure is applied, may be damaged. Additionally, due to a propagation of cracks on the edge, brittle fractures may occur in the upper glass substrate 11.

In the photoelectric device of FIG. 7, the two glass substrates, namely, the upper and lower glass substrates 11 and 12, coupled to each other with the photoelectric module 50 therebetween are required, and also the sealing material 41 sealing between the two glass substrates 11 and 12 is required. At this point, a position alignment between the two glass substrates 11 and 12 or between the two glass substrates 11 and 12, the sealing material 40, and the photoelectric module 50 is required. In order to improve the sealability of the sealing material 40, process conditions such as heating/pressurizing need to be strictly controlled. That is, due to the increase in the number of processes and strict process management, workability becomes worse and product costs rise. Additionally, the edges of the glass substrates 11 and 12 that the sealing material 40 occupies correspond to an area that is sacrificed for sealing the photoelectric module 50 and also corresponds to a void area that does not contribute to photoelectric conversion. Accordingly, since a valid light-receiving area is reduced by an area that the sealing material 40 occupies, electrical output is correspondingly reduced.

On the other hand, the photoelectric device according to the invention may be assembled in a way that the photoelectric module 150 is received in the receiving space G of the cover glass 110. Due to the simple manner in which the photoelectric module 150 is received in the receiving space G of the cover glass 110 without requiring the position alignment between a plurality of components, e.g., the two glass substrates 11 and 12, the sealing material 40, and the photoelectric module 50, as shown in the comparative example of FIG. 7, the position alignment between the cover glass 110 and the photoelectric module 150 may be readily obtained. For example, the cover glass 110 and the photoelectric module 150 are disposed to face each other, and the sealing material 120 interposed between the cover glass 110 and the photoelectric module 150 fills therein the gap therebetween by applying pressure and pressing the cover glass 110 and the photoelectric module 150, so that the assembly process of the photoelectric device may be completed.

Additionally, since the sidewall(s) 110b of the cover glass 110 seals the side section 150b of the photoelectric module 150, as shown in the comparative example of FIG. 7, strict process management for heating and pressing to enhance the sealability of the sealing material 40 is not required. Additionally, a void area due to the sealing material 40 may be removed.

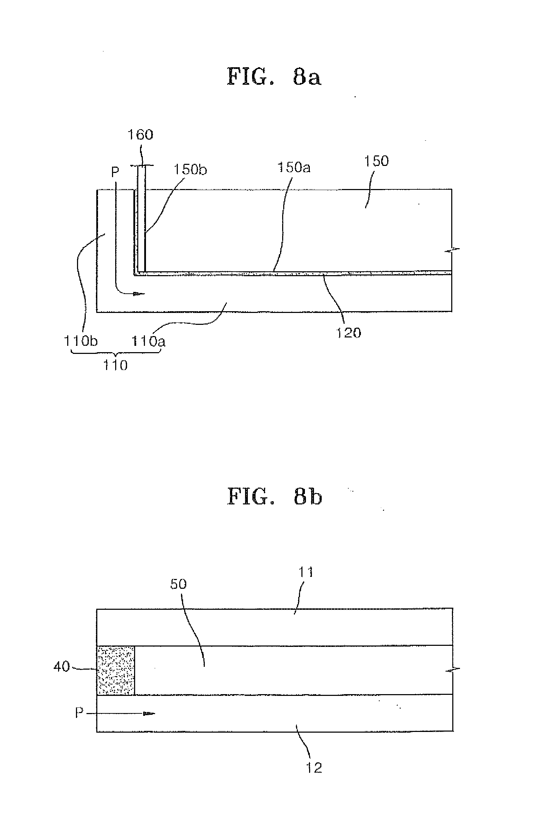

FIGS. 8a and 8b illustrate views of a penetration path P of contaminants penetrating into a photoelectric device according to embodiments of the invention and the comparative example, respectively. Referring to FIG. 8a, a contaminant, e.g., moisture, may penetrate into the photoelectric device along the lead wire 160 extending from the photoelectric module 150 to the outside. According to the comparative example of FIG. 8b, the length of the penetration path P is relatively short. However, according to the embodiment of FIG. 8a, the length of the penetration path P is increased through the sidewall 110b of the cover glass 110 and the side section 150b of the photoelectric module 150, so that this may greatly delay or prevent the penetration of contaminants.

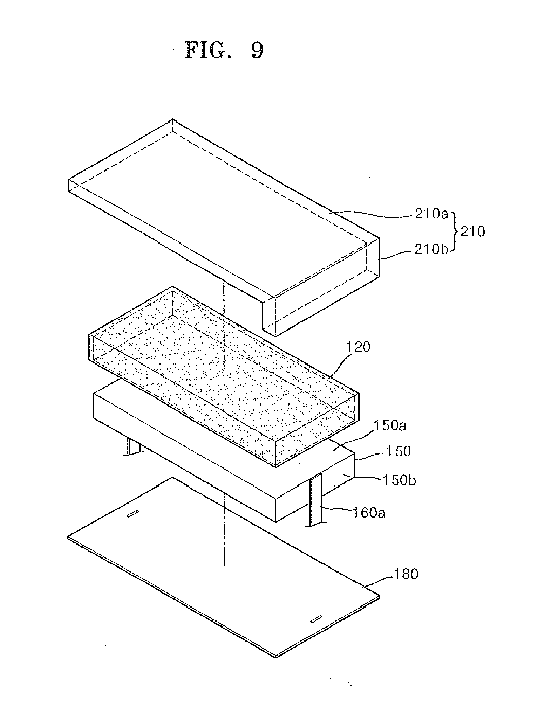

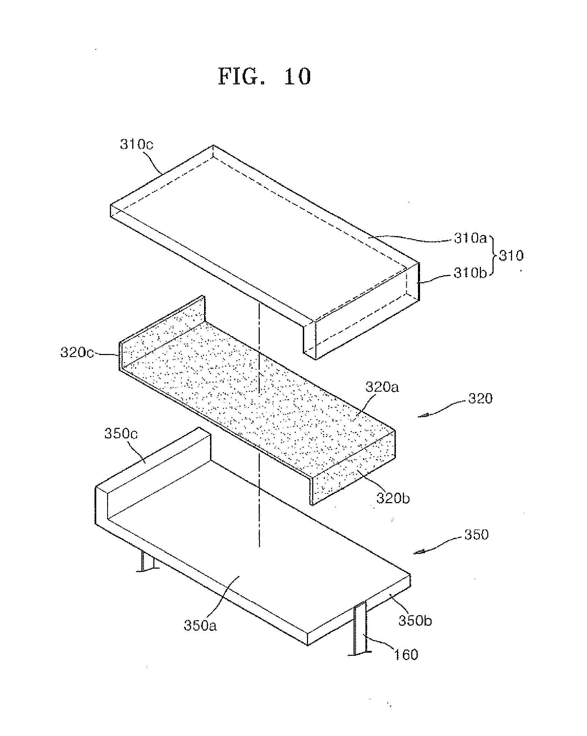

FIGS. 9 and 10 illustrate views of photoelectric devices according to different embodiments of the invention. Referring to FIG. 9, a cover glass 210 is formed to overlap, e.g., completely overlap, only one side section 150b of the photoelectric module 150. In this example, where the photoelectric module 150 is formed with an approximately rectangular type form, the cover glass 210 is formed to selectively overlap only one side section 150b of the photoelectric module 150. In this regard, the cover glass 210 includes a base part 210a disposed to face the main surface 150a of the photoelectric module 150, and a sidewall 210b disposed to overlap, e.g., completely overlap, the one side section 150b of the photoelectric module 150.

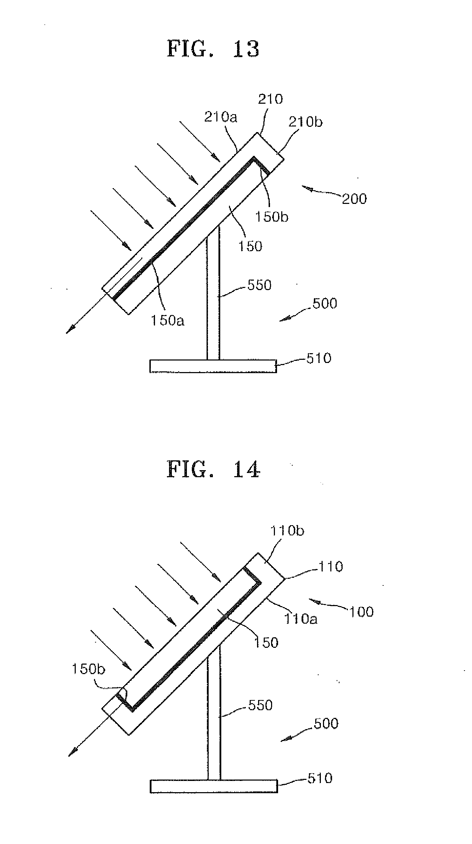

As mentioned later, the photoelectric device may be obliquely disposed at an upward position from the bottom surface through a mounting frame (see FIG. 13), and accordingly, may be disposed in a direction in which the photoelectric device receives incident light through the front according to the altitude of the sun. In such an obliquely disposed structure, in order to prevent the cover glass 210 and the photoelectric module 150 from being separated from each other due to the influence of gravity, the sidewall 210b of the cover glass 210 may be supported and caught by the side section 150b of the photoelectric module 150. For this purpose, even when the sidewall 210b is formed only as one short edge part of the cover glass 210, e.g., extends along the y-axis direction, the cover glass 210 and the photoelectric module 150 support each other enough against gravity.

Referring to FIG. 10, a cover glass 310 and a photoelectric module 350 respectively include a sidewall 310b and 350a, so as to support the coupling of each other. That is, the cover glass 310 has the sidewall 310b to overlap, e.g., completely overlap, one side section 350b of the photoelectric module 350, and the photoelectric module 350 has the sidewall 350c to overlap, e.g., completely overlap, one side section 310c of the cover glass 310. In other words, as would be apparent to one of ordinary skill in the art from the foregoing description and FIG. 10, the sidewall 310b of the cover glass 310 may extend from a base part 310a, e.g., along a short edge or y-axis direction, and protrude therefrom along the z-axis direction towards and overlap, e.g., completely overlap, the photoelectric module 350 along one side section 350b thereof. In a complementary fashion, the sidewall 350c of the photoelectric module 350 may extend from a base part 350a, e.g., along a short edge or y-axis direction opposite that of the sidewall 310b along the x-axis direction, and protrude therefrom along the z-axis direction towards and overlap, e.g., completely overlap, the cover glass 310 along one side surface 310c thereof.

Since the photoelectric module 350 and the cover glass 310 support each other, support strength may be enhanced. A sealing material 320 formed along the interface of the photoelectric module 350 and the cover glass 310 is interposed therebetween, so as to seal the gap and couple them. In other words, as would be apparent to one of ordinary skill in the art from the foregoing description and FIG. 10, the sealing material 320 would include a sidewall 320b and a sidewall 320c. In particular, the sidewall 320b extends from a base part 320a, e.g., along a short edge or y-axis direction, and protrude therefrom along the z-axis direction towards and overlap, e.g., completely overlap, one side section 350b of the photoelectric module 350 and the sidewall 310b of the cover glass 310. The sidewall 320c extends from the base part 320a, e.g., along a short edge or y-axis direction opposite that of the sidewall 320b along the x-axis direction, and protrudes therefrom along the z-axis direction towards and overlap e.g., completely overlap, one side section 310c of the cover glass 310 and the sidewall 350c of the photoelectric module 350.

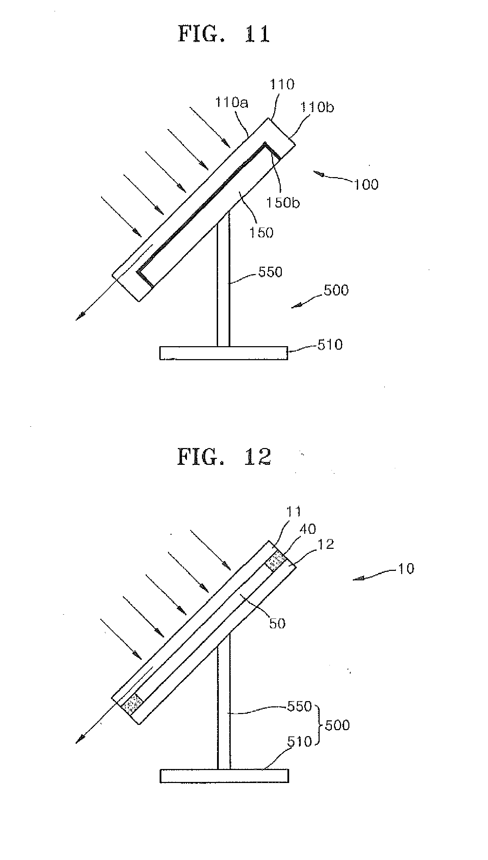

FIG. 11 illustrates a view of a photoelectric system according to another embodiment of the invention. Referring to the drawing, the photoelectric system includes a photoelectric device 100 and a mounting frame 500 supporting the photoelectric device 100 obliquely at an upward position from the ground. According to the embodiment of FIG. 11, the mounting frame 500 includes a bottom frame 510 and a support frame 550 supporting the photoelectric device 100 at a predetermined height from the bottom frame 510. However, the mounting frame 500 is not limited to the above, and thus may have various structures other than the one above. For example, the mounting frame 500 may further include a rotation structure and may adjust the light-receiving direction of the photoelectric device 100 through the rotation structure. For example, the light-receiving direction of the photoelectric device 100 may be adjusted to maximize the amount of light received according to the altitude of the sun.

The mounting frame 500 is disposed opposite to the light-receiving surface of the photoelectric device 100, i.e., the bottom of the photoelectric device 100, in order not to block the path of light incident to the photoelectric device 100. For convenience of description, the upward or upper side means the light-receiving surface of the photoelectric device 100 and the downward or bottom side means the non-light-receiving surface of the photoelectric device 100.

In more detail, with respect to the orientation of the photoelectric device 100, the cover glass 110 is disposed at the top and the photoelectric module 150 is disposed at the bottom, and the mounting frame 500 is disposed at the backside of the photoelectric module 150.

The mounting frame 500 is coupled to the photoelectric module 150 and includes a coupling bracket (not shown) for coupling to the photoelectric module 150. The cover glass 110 is mounted through the photoelectric module 150. In more detail, the sidewall 110b of the cover glass 110 is caught by the side section 150b of the photoelectric module 150, so that it is prevented from moving in the direction of gravity. Therefore, the cover glass 110 may be mounted on the mounting frame 500. By doing so, the photoelectric device 100 is completely mounted on the mounting frame 500 with a relatively simple mounting structure and no additional support structure to support the cover glass 110 against gravity, e.g., a stopper structure that stops movement in the direction of gravity, is needed.

FIG. 12 is a view of a photoelectric system including the photoelectric device according to the comparative example of FIG. 7. Referring to FIG. 12, the photoelectric device according to the comparative example includes the upper and lower glass substrates 11 and 12 coupled to face each other with the photoelectric module 50 therebetween. The sealing material 40 is interposed between the upper and lower glass substrates 11 and 12 so as to seal them. The sealing material 40 interposed between the upper and lower glass substrates 11 and 12 may not have an enough coupling strength to firmly couple them through thermal bond, and accordingly, the upper and lower glass substrates 11 and 12 may slide relative to each other and may be separated from each other due to the influence of gravity. Accordingly, a mounting frame for mounting the photoelectric device according to the comparative example is required to have an additional stopper structure (not shown) for supporting each of the upper and lower glass substrates 11 and 12, which may increase the costs of the mounting frame and the number of total manufacturing processes due to a coupling process.

FIG. 13 illustrates a view of a photoelectric system according to another embodiment of the invention. The photoelectric system includes a photoelectric device 200 and the mounting frame 500 on which the photoelectric device 200 is mounted. Referring to the drawings, the photoelectric device 200 includes the photoelectric module 150 and the cover glass 210 of FIG. 9 at the light-receiving surface of the photoelectric module 150. The cover glass 210 includes the base part 210a having a plate shape that faces the main surface 150a of the photoelectric module 150 and the sidewall 210b protruding from the base part 210a. The sidewall 210b is formed at the edge of the base part 210a. According to this embodiment, the sidewall 210b is selectively formed at one edge of the base part 210a.

In more detail, as shown in the drawings, the sidewall 210b is disposed to face one side section 150b of the photoelectric module 150 in order to allow the sidewall 210b of the cover glass 210 to be caught and fixed by the side section 150b of the photoelectric module 150. In this case, the sidewall 210b may be formed to overlap, e.g., completely overlap, the side section 150b at an uppermost position among the side sections 150b of the photoelectric module 150.

FIG. 14 illustrates a view of a photoelectric system according to another embodiment of the invention. Referring to the drawing, the photoelectric system includes the photoelectric device 100 and the mounting frame 500 on which the photoelectric device 100 is mounted. In more detail, with respect to the orientation of the photoelectric device 100, the photoelectric module 150 is disposed at the top, and the cover glass 110 is disposed at the bottom of the photoelectric module 150 to face the photoelectric module 150. In such a structure, the mounting frame 500 is installed at the backside of the cover glass 110, and the photoelectric module 150 is supported by the cover glass 110. That is, since the sidewall 110b of the cover glass 110 supports the side section 150b of the photoelectric module 150, the photoelectric module 150 may be fixed at a position against gravity.

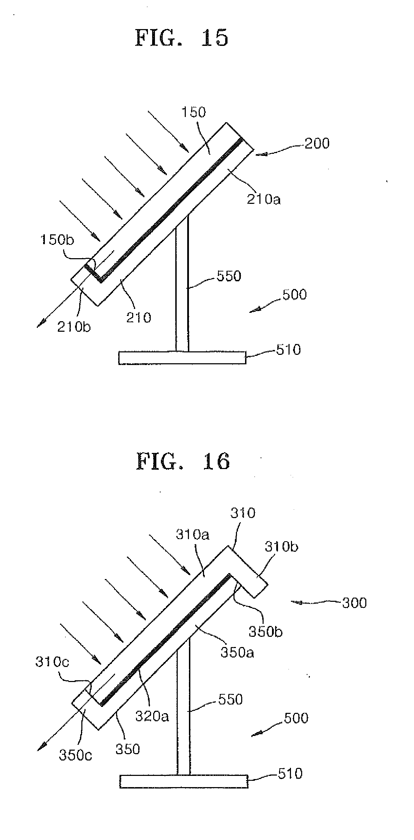

FIG. 15 illustrates a view of a photoelectric system according to another embodiment of the invention. Referring to the drawing, with respect to the orientation of the photoelectric device 200, the photoelectric module 150 is disposed at the top and the cover glass 210 is disposed at the bottom of the photoelectric module 150. In such a structure, the mounting frame 500 is installed at the backside of the cover glass 210, and the photoelectric module 150 is supported by the cover glass 210.

The sidewall 210b of the cover glass 210 is formed to overlap, e.g., completely overlap, one side section 150b of the photoelectric module 150. In this case, the sidewall 210b of the cover glass 210 is formed to overlap, e.g., completely overlap, one side section 150b at a lowermost position in the photoelectric module 150. Accordingly, the photoelectric module 150 may be fixed at a position against gravity without sliding through the sidewall 210b of the cover glass 210.

FIG. 16 is a view of a photoelectric system according to another embodiment of the invention. Referring to the drawing, the photoelectric system includes a photoelectric device 300 and the mounting frame 500 on which the photoelectric device 300 is mounted. The photoelectric device 300 includes the photoelectric module 350 and the cover glass 310 of FIG. 10, which are disposed to face each other. Also, the photoelectric module 350 and the cover glass 310 include sidewalls 310b and 350a, which respectively face side sections 310c and 350b of the cover glass 310, and the photoelectric module 350, that is, the opponent of the coupling, at respectively opposite sides. In more detail, the cover glass 310 has the sidewall 310b to face one side section 350b of the photoelectric module 350, and the photoelectric device 350 has the sidewall 350a to face one side section 310c of the cover glass 310. In this case, the sidewalls 310b and 350a of the cover glass 310 and the photoelectric module 350 may be formed at respectively opposite sides. For example, when the cover glass 310 and the photoelectric module 350 are formed in rectangular forms that correspond to each other, the sidewalls 310b and 350a of the cover glass 310 and the photoelectric module 350 may be formed at first and second short edge parts at respectively opposite positions. According to another embodiment, the sidewalls 310b and 350a of the cover glass 310 and the photoelectric module 350 may be formed at first and second long edge parts at respectively opposite positions.

Since the sidewalls 310b and 350a are formed at the positions where the cover glass 310 and the photoelectric module 350 coupled to face each other are staggered, the support strength for each other of the cover glass 310 and the photoelectric module 350 may be improved, and also, the whole photoelectric device 300 may be completely supported by the mounting frame 500. In more detail, referring to FIG. 16, the cover glass 310 is disposed at the top and the photoelectric device 300 is disposed to allow the photoelectric module 350 to be disposed at the bottom. The mounting frame 500 is disposed at the backside of the photoelectric device 300. In this case, the sidewall 350a of the photoelectric module 350 supports the cover glass 310 at a lower position, and the cover glass 310 is supported again at an upper position by the side section 350b of the photoelectric module 350. Therefore, the cover glass 310 is fixed at a position against gravity with sufficient support strength.

In the photoelectric systems shown in FIGS. 11 and 13 to 16, the photoelectric devices 100, 200, and 300 are disposed at a predetermined tilt angle with respect to the ground. For example, the tilt angle may vary depending on the latitude of the installation position, and as a photoelectric device is located in a higher latitude region, its tilt angle and the altitude of the sun may be increased simultaneously. For example, the tilt angle may be a vertical angle or an angle close to vertical.

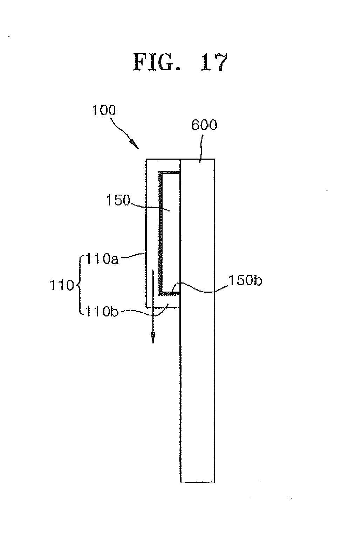

FIG. 17 illustrates a view of when the photoelectric device 100 is mounted at an outer wall of a building 600, according to another embodiment of the invention. The photoelectric device 100 may be installed at the outer wall of the building 600, without a mounting frame. For example, the photoelectric device 100 may be installed on the outer wall of the building 600 through a structure such as a mounting bracket (not shown) or may be attached to the outer wall of the building 600 through an adhesive (not shown). Similarly, in relation to the embodiments of FIGS. 11 and 13 to 16, the photoelectric devices 100, 200, and 300 may be supported by the outer wall of the building 600 without the mounting frame 500. In various embodiments, the cover glass 110 or the photoelectric module 150 may be supported by the sidewall 110b of the cover glass 110. Also, even when the sidewall 110b of the cover glass 110 and the side section 150b of the photoelectric module 150 support each other and only one backside of the cover glass 110 and the photoelectric module 150 is fixed at the outer wall of the building 600, the whole photoelectric device 100 may be completely supported.

According to embodiments of the invention, a sealing property of a photoelectric module may be improved using a cover glass having a sidewall. For example, the penetration of foreign materials may be greatly blocked or prevented by increasing the penetration path of foreign materials such as moisture. Additionally, assembly processes of the cover glass and a photoelectric module may be simplified and a convenient process management may be provided.

Furthermore, a support structure between a cover glass and a photoelectric module is formed by the cover glass. Therefore, in a photoelectric structure that is obliquely installed to receive incident light through the front according to the altitude of the sun, the mounting structure of the photoelectric module is simplified so that the whole photoelectric module may be completely supported.

Example embodiments of the invention have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A photoelectric device, comprising:
a photoelectric module configured to perform photoelectric conversion; and
a cover glass disposed to face the photoelectric module and having a receiving space that receives the photoelectric module,
wherein the cover glass includes a plate-shaped base part facing a main surface of the photoelectric module and a sidewall protruding from an edge of the base part to face a side section of the photoelectric module.

2. A photoelectric device as claimed in claim 1, wherein the side section of the photoelectric module and the sidewall of the cover glass support each other.

3. A photoelectric device as claimed in claim 1 or 2, wherein the sidewall of the cover glass overlaps at least one side section of the photoelectric module.

4. A photoelectric device as claimed in any preceding claim, wherein the photoelectric module is coupled to the cover glass by being received in the receiving space of the cover glass.

5. The photoelectric device as claimed in any preceding claim, wherein a sealing material is disposed between the photoelectric module and the cover glass.

6. The photoelectric device as claimed in claim 5, wherein the sealing material is disposed between the photoelectric module and the cover glass at all opposing surfaces thereof.

7. A photoelectric device as claimed in any preceding claim, wherein the photoelectric module has four side sections and the sidewall of the cover glass includes sidewalls that overlap all four side sections of the photoelectric module.

8. A photoelectric device as claimed in one of claims 1 to 6, wherein:
the photoelectric module and the cover glass are coupled to face each other, and
each of the photoelectric module and the cover glass has a sidewall formed to face a corresponding side section of the cover glass and the photoelectric module.

9. A photoelectric device as claimed in claim 8, wherein the sidewalls of the photoelectric module and the cover glass are formed at respectively opposite sides.

10. A photoelectric device as claimed in any preceding claim, further comprising a lead wire extending to the outside through a gap between the side section of the photoelectric module and the sidewall of the cover glass.

11. A photoelectric device as claimed in claim 10, wherein the lead wire includes:
a main body extending along a first direction in the photoelectric module; and
a connection end extending from the main body to the outside of the photoelectric module.

12. A photoelectric device as claimed in claim 11, wherein the connection end extends outside from an end of the main body along a second direction, orthogonal to the first direction, of the main body.

13. A photoelectric device as claimed in claim 11, wherein the connection end includes a first extension that extends along a second direction, orthogonal to the first direction, from an end portion of the main body, and a second extension that extends from the first extension along a third direction, orthogonal to the first and second direction, to extend to the outside.

14. A photoelectric device as claimed in claim 11, wherein the connection end extends outside from a middle section of the main body along a second direction, orthogonal to the first direction, of the main body.

15. A photoelectric system, comprising:
a photoelectric device according to any preceding claim; and
a mounting frame supporting the photoelectric device obliquely at an upper position from the ground, wherein:
the mounting frame is mounted to a lower one of the photoelectric module and the cover glass.

16. The photoelectric system as claimed in claim 15, wherein the sidewall overlaps a side section disposed uppermost or lowermost in the photoelectric module.

17. The photoelectric system as claimed in claim 15 or 16, wherein:
the cover glass is supported at an upper part of the photoelectric module, and
the sidewall of the cover glass is supported by the side section of the photoelectric module.

18. The photoelectric system as claimed in claim 15 or 16, wherein:
the photoelectric module is supported at an upper part of the cover glass, and
the side section of the photoelectric module is supported by the sidewall of the cover glass.
